(19) Europäisches Patentamt
European Patent Office
Office européen des brevets

(11) **EP 2 529 406 B1**

(12) **EUROPÄISCHE PATENTSCHRIFT**

(45) Veröffentlichungstag und Bekanntmachung des Hinweises auf die Patenterteilung:
**03.06.2020 Patentblatt 2020/23**

(21) Anmeldenummer: **11701462.1**

(22) Anmeldetag: **27.01.2011**

(51) Int Cl.:
*H01L 31/0224* (2006.01)    *G02F 1/1343* (2006.01)
*H01L 31/0236* (2006.01)    *H01L 31/18* (2006.01)

(86) Internationale Anmeldenummer:
**PCT/EP2011/000371**

(87) Internationale Veröffentlichungsnummer:
**WO 2011/092017 (04.08.2011 Gazette 2011/31)**

(54) **VERFAHREN ZUR HERSTELLUNG EINES BESCHICHTETEN GEGENSTANDS MIT TEXTURÄTZEN**

METHOD FOR PRODUCING A COATED ITEM BY MEANS OF TEXTURE ETCHING

PROCÉDÉ DE FABRICATION D'UN OBJET REVÊTU PAR GRAVURE DE TEXTURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.05.2010 DE 102010020994**
**27.01.2010 DE 102010005888**

(43) Veröffentlichungstag der Anmeldung:
**05.12.2012 Patentblatt 2012/49**

(73) Patentinhaber: **INTERPANE Entwicklungs-und Beratungsgesellschaft mbH**
**37697 Lauenförde (DE)**

(72) Erfinder:
• **KAPPERTZ, Oliver**
**33098 Paderborn (DE)**
• **HERLITZE, Lothar**
**37691 Derental (DE)**
• **WEIS, Hansjörg**
**37671 Höxter (DE)**
• **PURWINS, Michael**
**37170 Offensen (DE)**

(74) Vertreter: **Körfer, Thomas**
**Mitscherlich PartmbB**
**Patent- und Rechtsanwälte**
**Sonnenstrasse 33**
**80331 München (DE)**

(56) Entgegenhaltungen:
**EP-A1- 1 577 949        WO-A2-2009/019376**
**US-A- 4 554 727         US-A- 4 732 621**
**US-A1- 2007 082 418     US-A1- 2009 194 157**
**US-A1- 2010 003 781**

**Beschreibung**

Die Erfindung betrifft ein Verfahren zur Herstellung eines beschichteten Gegenstands, wobei die Beschichtung sowohl transparent als auch leitfähig ist.

Transparente leitfähige Beschichtungen können in vielfältiger Weise eingesetzt werden. Von besonderer Bedeutung ist dabei die Funktion als transparente Frontelektrode in Dünnschicht-Solarzellen, sowie bei Flachbildschirmen. Andere Anwendungen beinhalten Kontakte für Elektrolumineszenzquellen, zur Ansteuerung von Flüssigkristallen, elektrochrome Beschichtungen, für transparente Heizelemente und Anti-Beschlag-Beschichtungen (englisch: antifogging). Zusätzlich sind bei entsprechendem Reflexionsvermögen im Infrarot Anwendungen im Bereich Radarentspiegelung, Wärmeschutz und Brandschutz möglich.

Die Herstellung dieser Beschichtung ist üblicherweise ausgesprochen aufwändig, um die widersprüchlichen Eigenschaften Transparenz und Leitfähigkeit zu vereinen. Insbesondere sind hohe Temperaturen des zu beschichtenden Gegenstands erforderlich. Gerade bei Vakuumbeschichtungsverfahren ist das Heizen während des Prozesses ein erhebliches Problem, dass nur mit hohen Kosten gelöst werden kann. Zusätzlich muss die Beschichtung für die Anwendung in Solarzellen eine bestimmte Rauigkeit aufweisen, um eine ausreichende Lichtstreuung zu gewährleisten. Andererseits soll die Lichtstreuung für die anderen möglichen Anwendungen üblicherweise möglichst gering sein. Damit ist die Oberflächentextur nach Leitfähigkeit und Transparenz die dritte Schichteigenschaft, die gleichzeitig erfüllt sein muss.

Ein mögliches Vorgehen ist dabei, beispielsweise ein Glasband direkt nach der Herstellung noch bei ca. 600°C mit Zinnoxid zu beschichten. Hierbei werden alle drei Parameter gleichzeitig eingestellt; entsprechend bietet ein derartiger Prozess nur eingeschränkte Optimierungsmöglichkeiten.

Ein weiteres Verfahren besteht darin, Zinkoxid bei ca. 300°C in einer Vakuumbeschichtung aufzubringen, und die Oberflächentextur durch einen zusätzlichen Ätzschritt einzustellen. Das Problem hierbei besteht darin, das Substrat gleichmäßig und effizient aufzuheizen, sowie anschließend wieder kontrolliert abzukühlen, ohne dass es zu thermischen Brüchen kommt.

Aus der WO 2007/018975 A1 ist zwar das Tempern von TCO-Beschichtungen im Vakuum jedoch ohne Textur-Ätzen bekannt.

Patentdokumente WO 2009/019376 A2 und US 2007/082418 A1 offenbaren Verfahren zur Strukturierung von transparent leitfähigen Oxidschichten.

Die Aufgabe der vorliegenden Erfindung besteht darin ein Verfahren zur Herstellung eines beschichteten Gegenstands zu schaffen, das die oben genannten Nachteile vermeidet, wobei dabei die elektrische Leitfähigkeit, optische Transparenz und Streuung des beschichteten Gegenstands eingestellt werden kann.

Die Aufgabe wird durch das erfindungsgemäße Verfahren mit den Merkmalen des Anspruch 1 gelöst. In den Unteransprüchen sind vorteilhafte Weiterbildungen des erfindungsgemäßen Verfahrens, dargestellt.

Die Erfindung basiert auf einer vollständigen Trennung der einzelnen Prozessschritte Abscheidung mindestens einer transparenten leitfähigen Metalloxidschicht auf einem Substrat, umfassend die Abscheidung und gegebenenfalls anschließende Temperaturbehandlung der Beschichtung, und das statistische Einstellen der Oberflächentextur der Beschichtung durch ein Ätzverfahren.

Als besonders vorteilhaft stellt sich ein Ätzverfahren heraus, bei dem vor dem Ätzen eine Maske auf die Beschichtung durch Sputtern als nicht geschlossene Schicht oder in Inseln aufgebracht wird. Vorzugsweise beträgt die mittlere Dichte der Maske höchstens 15nm, weiter bevorugt höchstens 10nm, insbesondere bevorzugt höchstens 5nm. Die Materialien für die Maske können aus Materialien ausgewählt werden, die langsamer in HCl geätzt werden als mit Al dotiertes $ZnO_x$ ($x \leq 1$), vorzugsweise werden sie aus der aus $SnO_x$, $SnZnO_x$, $TiO_x$, $SiO_x$, mit Al dotiertes $SiO_x$, $InSnO_x$ (ITO), insbesondere mit N oder C angereichertes $InSnO_x$ (ITO), wobei $x \leq 2$, ausgewählt.

Als zweite Methode des Ätzverfahrens wird vor dem Ätzen auf der Beschichtung unter Verwendung eines Komplexbildners eine Maske in situ, insbesondere durch ein nasschemisches Tauch- oder Sprühverfahren, erzeugt. Vorzugsweise wird als Komplexbildner hierbei mindestens ein Element aus der aus Oxalsäure, Malonsäure und Acetylaceton bestehenden Gruppe, vorzugsweise Oxalsäure oder Malonsäure eingesetzt. Auf diese Weise setzen sich unlösliche Metallkomplexsalze auf dem Substrat haufenförmig ab, wobei die Haufen auf der Oberfläche des Substrats statistisch verteilt sind. Beispielsweise bilden sich bei Verwendung von Zinkoxid als Substrat Zinkmalonat oder Zinkoxalat. Die Haufenbildung kann weiter verbessert werden, wenn gleichzeitig mit oder nach Zugabe des Komplexbildners eine nicht-komplexbildende Säure, vorzugsweise eine Monocarbonsäure, insbesondere bevorzugt Essigsäure eingesetzt wird. Auf diese Weise wird der Kontrast zwischen Metalloxidhaufen und Substrat schärfer, was zur Maskenbildung vorteilhaft ist.

Als dritte Methode des Ätzverfahrens wird vor dem Ätzen zur Erzeugung einer Maske ein nicht reaktives Pulver, vorzugsweise mindestens ein Element aus der aus $Al_2O_3$, $SiO_2$ und $BaSO_4$ bestehenden Gruppe, auf die Beschichtung mechanisch abgelegt.

Als vierte Methode des Ätzverfahrens werden vor dem Ätzen zur Erzeugung einer Maske Oligomere, vorzugsweise Siloxanoligomere, auf die Beschichtung gestreut und selektiv angebunden.

Vorzugsweise wird nach Erzeugung der Maske mit mindestens einer Broensted oder Lewissäure, vorzugsweise mit mindestens einem Element aus der aus Essigsäure, Zitronensäure, Ameisensäure, Eisentrichlorid, Aluminiumtrichlorid und Salzsäure bestehenden Gruppe, insbesondere bevorzugt Salzsäure, geätzt.

Bezüglich des vor dem Ätzverfahren stattfindenden Verfahrensschrittes der Abscheidung mindestens einer transparenten leitfähigen Metalloxidschicht auf einem Substrat, wobei der Verfahrensschritt die Abscheidung und anschließende Temperaturbehandlung der Beschichtung umfasst, ist Folgendes bevorzugt:

Vorzugsweise wird die Beschichtung aus $ZnO_y$, vorzugsweise aus mit Al dotiertem $ZnO_y$, insbesondere aus mit bis zu 2at% Al bezogen auf Zn dotiertem $ZnO_y$, wobei $0<y\leq1$ ist, hergestellt.

Das Aufbringen der Beschichtung wird vorzugsweise bei einer Substrattemperatur von höchstens 180°C, weiter bevorzugt höchstens 160°C, noch weiter bevorzugt höchstens 150°C, insbesondere bevorzugt höchstens 130°C vorgenommen. Dies kann beispielsweise erreicht werden, wenn auf eine zusätzliche Aufheizung des Substrats vor Beginn der Abscheidung verzichtet wird.

Der wichtigste physikalische Parameter des erfindungsgemäßen Verfahrens zur Einstellung der elektrischen Leitfähigkeit und der optischen Transparenz durch eine nachfolgende Temperbehandlung ist die Temperatur T bei der Temperaturbehandlung der aufgebrachten Beschichtung. Es stellt sich heraus, dass die Temperaturbehandlung besonders effektiv mittels Laserstrahlung erfolgen kann. Durch diesen Ansatz kann die Temperaturbehandlung sowohl an Umgebungsluft als auch im Vakuum erfolgen.

Als besonders vorteilhaft stellt sich eine Strahlgeometrie heraus, bei der durch entsprechende Optiken der Laserstrahl als schmale Linie ausgeführt ist. Diese Linie wird z.B. von gekoppelten Laserdioden oder gekoppelten Nd:YAG- oder Er:YAG-Laser oder Ho:YAG-Laser oder $CO_2$-Laser oder Yb:YAG -Lasern, z.B. als Stab- oder Scheibenlaser, erzeugt, bei deren Wellenlänge die Schicht absorbierend ist. Evtl. muss die Frequenz vervielfacht werden.

Die Laserbehandlung in einer Laserbestrahlungsvorrichtung bewirkt dabei eine Verbesserung der Leitfähigkeit der Beschichtung, wobei gleichzeitig die Transparenz im Sichtbaren verbessert wird. Diese Verbesserungen sind so deutlich, dass es mit diesem Verfahren möglich ist, die Schichten kalt abzuscheiden, was üblicherweise zu geringen Ladungsträgerkonzentrationen und Ladungsträgerbeweglichkeiten bei gleichzeitig schlechter Transparenz führt, und durch diese Nachbehandlung Schichteigenschaften vergleichbar zu heiß abgeschiedenen Schichten zu erzielen.

Als zweite Methode der Temperaturbehandlung wird vorteilhaft das Erhitzen in einem Hochkonvektionsofen durch Ventilatoren und Heizstrahler oder in einem Zweikammerofen durch Heißluftgebläse und Heizstrahler bevorzugt außerhalb eines Vakuums angewendet. Der Hochkonvektionsofen sowie der Zweikammerofen haben den Vorteil, dass die Beschichtung und das Substrat, wobei auch in dieser Variante bevorzugt Glas als Substrat verwendet wird, sehr gleichmäßig, das heißt sehr homogen erhitzt wird. Vorteilhaft erübrigt sich bei einem Hochkonvektionsofen und auch bei einem Zweikammerofen die Schaffung eines Vakuums, da die Wärmeübertragung durch Konvektion geschieht.

Es können je nach Schichtmaterial und Dotierung spezifische Widerstände zwischen $80\mu\Omega cm$ und $5000\mu\Omega cm$ eingestellt werden. Je nach Anwendung sind Schichtwiderstände z.B. zwischen $1\Omega_{sq}$ und $500\Omega_{sq}$ möglich, was abhängig von Grundmaterial und Dotierung Schichtdicken zwischen 30nm und $2\mu m$ entspricht.

Die Metalloxidschicht besteht im Wesentlichen zum Beispiel aus Zinkoxid, Cadmiumoxid, Zinnoxid, Indiumoxid oder aus Mischungen von zwei oder mehrerer dieser Oxide. Vorzugsweise werden die Metalloxidschichten dotiert.

Die folgende Aufzählung enthält beispielhaft erfindungsgemäß verwendete Metalloxide und ihre Dotierungen. Bei den Metalloxidschichten gibt es prinzipiell zwei Typen: n-dotierte und p-dotierte Schichten.

Als n-dotierte Schichten werden die folgenden Verbindungen verwendet: Indiumzinnoxid (ITO) oder eine Verbindung der Struktur II-VI:III, wobei

II für Zn, Cd, Hg, Be, Mg, Ca, Sr, Ba,

III für B, Al, Ga, In, Sc, Y, La, Ce, Pr, Nd, Sm, Eu, Gd, Tb, Dy, Ho, Er, Tm, Yb, Lu, Cr, Mo, W

und IV für einatomigen Sauerstoff steht, wobei insbesondere ZnO:Al, ZnO:Ga, ZnO:B eingesetzt werden, oder eine Verbindung der Struktur

$IV-VI_2$:V, wobei

IV für Sn, Pb, Ti, Zr, Hf,

VI für O, S, Se,

und V für V (Vanadium), Nb, Ta, P, As, Sb

steht. Insbesondere werden bei dieser Struktur $SnO_2$:Sb und $TiO_2$:Nb verwendet. Auch ist eine Dotierung mit VII an Platz von VI möglich, wobei VII F oder Cl sein kann.

Bei den p-Typen kommen die folgenden Verbindungen zum Einsatz:

$IV-VI_2$:III, also insbesondere $TiO_2$:Cr,

$I-III-VI_2$ mit I = Cu, Ag, (Au), Li, insbesondere $CuAlO_2$, $CuCrO_2$ mit jeweils komplexen Dotierungsmöglichkeiten, - $I_2$- II- IV - $VI_4$, insbesondere $Cu_2ZnSnO_4$ mit ebenfalls komplexen Dotierungsmöglichkeiten. Auch ist eine Dotierung mit V an Platz von VI möglich, wobei V hier für N oder P steht.

Es kann eines oder mehrere der Elemente S, Se, Ca, Mg, Sr vorhanden sein, um die Lage der Valenz- und Leitungsbänder und damit auch die optische Bandlücke zu kontrollieren. Die Konzentration dieser zusätzlichen Elemente liegt bevorzugt zwischen 2at.% und 20at.%.

Die Ladungsträgerkonzentration und damit die elektrische Leitfähigkeit wird über die Zugabe von Dotierelementen wie Al, aber auch B, Ga, In, F, Cl, P, As, Sb eingestellt. Dabei werden bevorzugt Zinkoxid mit Al und Zinnoxid mit F dotiert. Bei einem Indium-dotierten Zinnoxid, betragen bevorzugt die Stoffanteile von Indium 60% bis 95%, besonders bevorzugt 90%, und von Zinn 5% bis 40%, besonders bevorzugt 10% (in at.%). Dieses Indium-dotierte Zinnoxid ist intrinsisch leitfähig. Die Konzentration der Dotierelemente zur Einstellung der elektrischen Leitfähigkeit beträgt zwischen 0,1at.% und 10at.%, bevorzugt zwischen 0,2at.% und 6at.%, besonders bevorzugt zwischen 0,4 at.% und 3 at.%, bezogen auf den Metallgehalt.

Nachfolgend wird die Offenbarung an Ausführungsbeispielen beispielhaft beschrieben. Es zeigen:

Fig.1      das Herstellungsverfahren im Überblick;
Fig.2      den ersten Verfahrensschritt am Beispiel einer Sputtervorrichtung;
Fig.3      einen beispielhaften Schichtaufbau;
Fig.4a-4c      eine schematische Darstellung des zweiten Verfahrensschritts der Temperaturbehandlung durch eine Laserbestrahlungsvorrichtung;
Fig.5a-5b      eine schematische Darstellung eines Laserbeleuchtungsmoduls und einer daraus erzeugten Laserlinie;
Fig.6      einen Hochkonvektionsofen;
Fig.7      die Temperaturbehandlung als zweiten Verfahrensschritt in einem Hochkonvektionsofen;
Fig.8      einen Zweikammerofen;
Fig.9      die Temperaturbehandlung als zweiten Verfahrensschritt in einem Zweikammerofen;
Fig.10      ein Referenz-Ätzverfahren;
Fig.11a-b      das erfindungsgemäße Ätzverfahren (III); und
Fig.12a-c      die Temperaturbehandlung durch einen gepulsten Yb:YAG/Scheibenlaser im Scan-Modus.

Die Bezugszeichen in allen Figuren sind konsistent gehalten, so dass jedes Teil in allen Figuren das gleiche Bezugszeichen trägt. Zunächst werden die Figuren im Einzelnen beschrieben. Danach folgen zwei Ausführungsbeispiele.

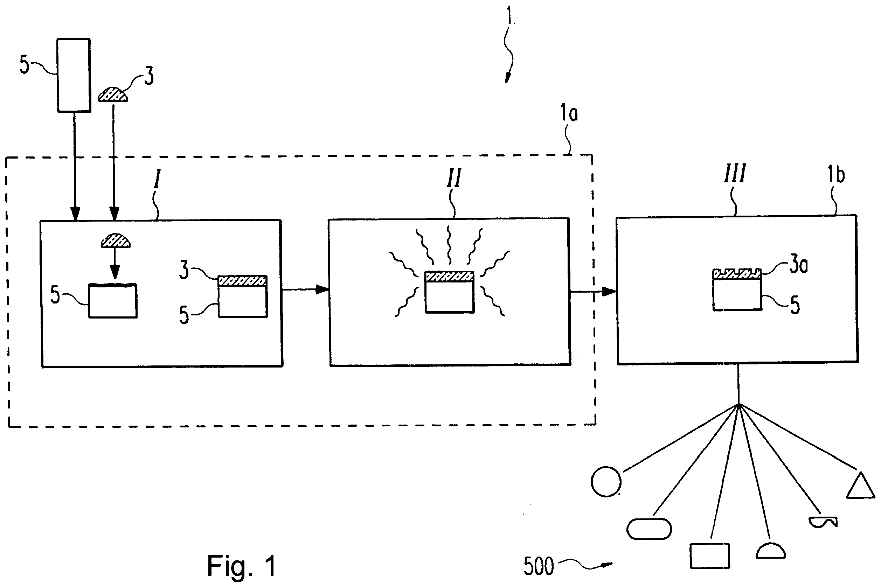

In Fig. 1 ist das Verfahren zur Herstellung eines beschichteten Gegenstands 2 mit seinen zwei bzw. drei Verfahrensschritten I Beschichten, II Erhitzen und III Ätzen dargestellt. Dabei bilden die beiden Verfahrensschritte I und III die erfindungsgemäße Lösung und optional kann zwischen die beiden Verfahrensschritte I und III ein Verfahrensschritt II - das Ätzen - eingefügt werden. Links oben sind die Ausgangmaterialien, das Beschichtungsmaterial 3 und dessen Träger, das sogenannte Substrat 5, welches bevorzugt aus Glas besteht, abgebildet.

Die Beschichtungsmaterialien sind ein oder mehrere Metalloxide, sogenannte TCOs, transparente, elektrisch leitfähige Oxide (transparent, conductive oxides). Im Verfahrensschritt I wird das Substrat 5 mit ein oder mehreren Metalloxiden beschichtet. Im Verfahrensschritt II wird das beschichtete Substrat 2 durch eine Temperaturbehandlung erhitzt, um die elektrische Leitfähigkeit und die optische Transparenz der Beschichtung 3 einzustellen, und im optionalen Verfahrensschritt III wird die Beschichtung 3 einer Ätzung zur Bildung einer Oberflächentextur 3a unterzogen. Wichtig ist dabei, dass die Verfahrensschritte I, II und III alle streng voneinander getrennt sind. Das Resultat aus den Verfahrensschritten I, III und dem optionalen Verfahrensschritt II ist ein beschichteter Gegenstand 2 für eine vielfältige Palette von Endprodukten 500, wie zum Beispiel Dünnschichtsolarzellen, Autoglasscheiben, die nicht beschlagen, radarentspiegelte Verkleidungen für Flughafengebäude usw..

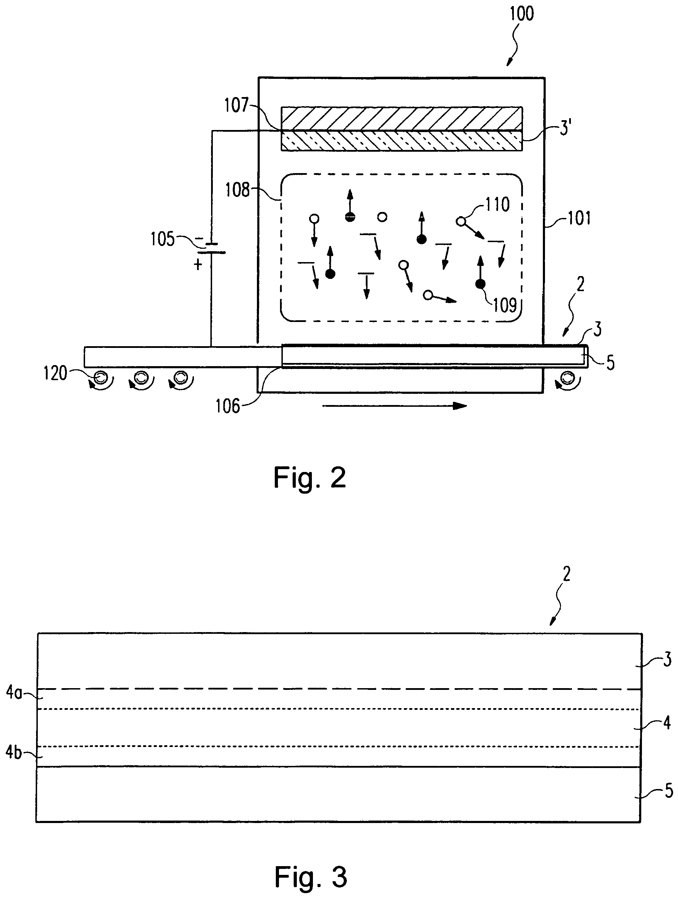

Fig. 2 zeigt eine beispielhafte Beschichtungsvorrichtung in Form einer Sputteranlage 100, bestehend aus einer Vakuumkammer 101 einer Spannungsversorgung 105, einer Anode 106, die hier durch das Substrat 5 verdeckt ist, und einer Kathode 107. In der Vakuumkammer 101 werden einem Festkörper 3'als Target, der aus einem transparenten, leitfähigen Metalloxid besteht, durch Beschuss mit energiereichen Ionen 109, die in einem elektrischen Feld, das die Anode 106 und die Kathode 107 bilden, beschleunigt werden, Atome bzw. Moleküle 110 herausgelöst. Diese Atome bzw. Moleküle 110 scheiden sich an der Oberfläche eines Substrats 5, das z.B. als Glasscheibe auf Walzen 120 mit konstanter Geschwindigkeit durch die Vakuumkammer 101 bewegt wird, ab. Diese Atome 110 bilden dann eine Beschichtung 3. Mit dieser Gasphasenabscheidung können ein oder mehrere Schichten auf das Substrat 5 aufgetragen werden.

Wenn das Targetmaterial selbst aus einem Festkörper 3' aus reinem Metall, also ohne Oxide besteht, kann das sogenannte reaktive Sputtern eingesetzt werden. Beim reaktiven Sputtern entsteht die Beschichtung 3 durch eine chemische Reaktion der aus dem Target 3' herausgelösten Atome, also Atome eines der vorgenannten Metalle mit einem Reaktionsgas, hier Sauerstoff, um eine Oxidschicht 3 auf der Oberfläche des Substrats 5 zu erzeugen. Die chemische Reaktion bei Zink mit Sauerstoff ist

$$2Zn + yO_2 \rightarrow 2ZnO_y,$$

wobei sich auf dem Substrat 5 eine Zinkoxidschicht 2 bildet, die bevorzugt etwas substöchiometrisch ist, d.h. $y < 1$. Auf diese Weise können auch mehrere Schichten verschiedener Metalloxide durch hintereinander ausgeführtes reaktives Sputtern aufgetragen werden.

Fig. 3 zeigt ein Beispiel für eine Beschichtung. Diese Beschichtung besteht aus 4 Schichten, welche von oben nach unten folgendermaßen angeordnet sind: Eine TCO-Schicht 3, die selbst wiederum aus mehreren TCO-Schichten verschiedener TCOs aufgebaut sein kann, einer Interferenzschicht 4a, einer Diffusionssperre 4 und eine weitere Interferenzschicht 4b. Die Diffusionssperre 4 kann auch selbst als Interferenzschicht ausgebildet sein.

Nun werden die Funktionen der Schichten 4a, 4 und 4b erklärt. Zur Verhinderung von Elektrokorrosion ist zwischen der TCO-Schicht 3 und dem Substrat 5 die Natrium-Diffusionssperre 4 eingefügt, so wie dies in Fig. 3 dargestellt ist. Die Dicke der Diffusionssperrschicht 4 beträgt dabei zwischen 5nm und 200nm, bevorzugt zwischen 10nm und 50nm. Besonders bieten sich Siliziumoxid, Siliziumnitrid, Siliziumcarbid, sowie Mischungen und/oder Verbindungen zweier oder aller dieser Substanzen an. Dabei ist eine leichte Abweichung von der stöchiometrischen Zusammensetzung vorteilhaft. Diese sollten jedoch bevorzugt in Summe 10% nicht überschreiten, da sonst die Absorption der Diffusionssperre 4 zu hoch wird. Insgesamt sollte die Absorption dieser Teilschicht 2% nicht überschreiten. Dieser Wert berechnet sich als Differenz der Summen aus Lichttransmission und -reflexion bei einer Wellenlänge von 515nm für jeweils das Schichtsystem ohne und mit dieser Diffusionssperre 4.

Zusätzlich zur Diffusionssperrwirkung erfolgt eine Entspiegelung durch destruktive Interferenz von an zwei verschiedenen Schichtgrenzen reflektierten Lichtwellenzügen der Wellenlänge $\lambda$ mit dem Gangunterschied $\lambda/2$: Eine sogenannte Interferenzentspiegelung. Dazu kann sowohl zwischen Diffusionssperrschicht 4 und TCO-Schicht 3 die Interferenzschicht 4a eingefügt werden als auch zwischen der Diffusionssperrschicht 4 und Substrat 5 eine entsprechende Interferenzschicht 4b eingefügt werden, wie in Fig.3 gezeigt. Die Dicke der Interferenzschichten 4a bzw. 4b betragen zwischen 20nm und 100nm. Die Interferenzschichten 4a, 4b wirken entspiegelnd. Bevorzugte Materialien sind Oxide, Nitride und Carbide von Silizium, Aluminium, Zink, Zinn, Titan, Zirkon, Hafnium, Vanadium, Niob, Tantal, sowie Mischungen zweier oder mehrerer dieser Substanzen. Es ist auch möglich, die Diffusionssperrschicht 4 selbst als Interferenzschicht auszubilden.

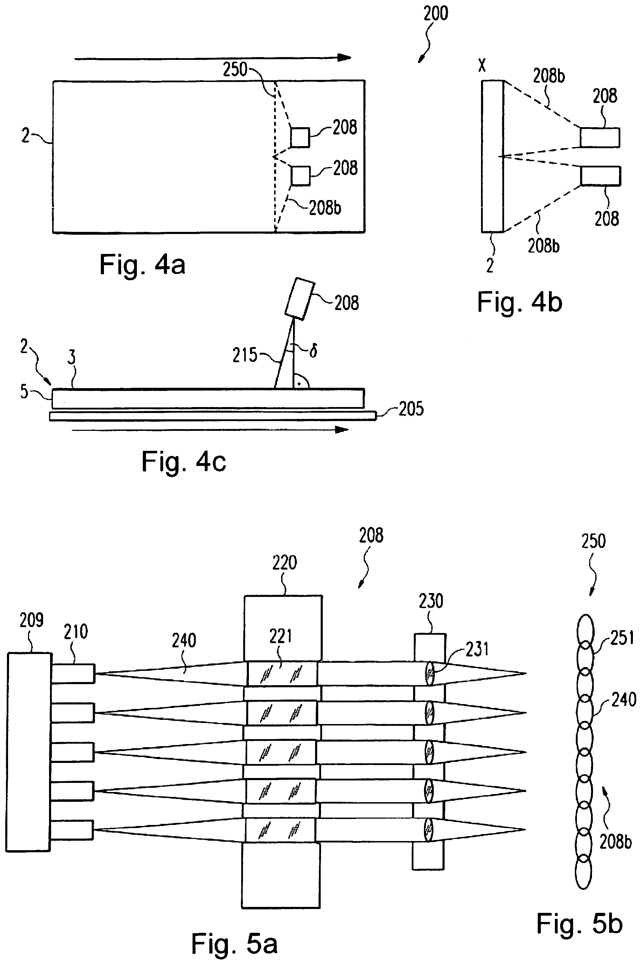

Die Figuren 4a, 4b und 4c, zeigen sehr schematisch eine beispielhafte Temperaturbehandlungsvorrichtung in Form einer Laserbestrahlungsvorrichtung 200, die den Substratkörper auf eine Temperatur $T_{IIa}$ erhitzt. Dabei zeigt Fig. 4a einen beschichtete Substratkörper 2 in Form einer rechteckigen Platte, die mit konstanter Geschwindigkeit $v_{IIa}$ in Pfeilrichtung bewegt wird, in einer Draufsicht. Über dem Substratkörper 2 sind zwei Laserbeleuchtungsmodule 208 angebracht, welche zwei Beleuchtungsbereiche 208b, eingezeichnet durch gestrichelte Linien, erzeugen, deren Licht in Form einer Laserlinie 250 fast senkrecht auf die Beschichtung 3 des Substratkörpers 2 auftrifft. Die Beschichtung 3 wird durch das Laserlicht erhitzt. Die Laserlinie 250 steht senkrecht zur Bewegungsrichtung der Substratkörpers 2.

Die Lasermodule sind so angeordnet, das die erzeugten linienförmigen Beleuchtungsbereiche 208b nebeneinander angeordnet zusammen den Substratkörper in seiner gesamten Breite erfassen. Alternativ ist es auch möglich, dass bereits jeder einzelne linienförmige Beleuchtungsbereich 208b den Substratkörper in seiner gesamten Breite erfasst.

Fig. 2b zeigt die Bestrahlung des Substratkörpers 2 durch zwei Laserbeleuchtungsmodule 208 in der Frontansicht. Die Abbildungsebene steht also senkrecht zur Bewegungsrichtung des Substratkörpers 2. Auch hier wird deutlich, dass beide Laserbeleuchtungsmodule 208 nebeneinander angeordnet zusammen die gesamte Substratkörperbreite erfassen.

Fig. 2c zeigt die Bestrahlung des Substratkörpers 2 in einer Seitenansicht. Der Laserstrahl 215 steht nicht ganz senkrecht zur beschichteten Oberfläche des Substratkörpers 2, um das Laserbeleuchtungsmodul 208 vor Selbstreflexionen am Substratkörper 2 zu schützen. Um dies zu verdeutlichen, ist der Winkel $\delta$ übertrieben groß dargestellt. Die Summe der Beleuchtungsbereiche 208b bildet immer eine scharfe Laserlinie, unter der der Substratkörper 2 entlang seiner gesamten Länge mit konstanter Geschwindigkeit $v_{IIa}$ auf einer Transporteinrichtung 205 bewegt wird.

Fig. 5a zeigt ein beispielhaftes Laserbeleuchtungsmodul 208, das jeweils einen Beleuchtungsbereich 208b erzeugt, der im Querschnitt eine scharfe Laserlinie 250 erzeugt, wie sie in Fig. 5b dargestellt ist. Mehrere Laser 210 sind im Ausführungsbeispiel auf einer Fixiervorrichtung 209 fixiert und sind im Ausführungsbeispiel zueinander parallel auf einer Geraden äquidistant ausgerichtet. Das Laserlicht, das die Laser 210 emittieren, läuft durch einen Kollimator 220, der Zylinderlinsen 221 beinhaltet, die das Laserlicht lateral begrenzen und parallelisieren. Dann trifft das parallelisierte Laserlicht auf einen Mikrolinsenarray 230, das durch seine asphärischen Linsen 231 das Laserlicht auf eine Laserlinie 250 fokussiert, wie in Fig. 5b dargestellt ist.

In Fig. 5a sind der Übersichtlichkeit wegen nur fünf fokussierte Laserstrahlen eingezeichnet. In Wirklichkeit stehen diese Laserstrahlen viel enger nebeneinander, so dass ihre Strahlkegel 240 einander überlappen, wie es in Fig. 5b gezeigt ist. Fig. 5b zeigt die Laserlinie 250 stark vergrößert gegenüber Fig. 5a. Die Strahlkegel 240 sind bedingt durch die asphärischen Linsen 231 im Querschnitt ellipsenförmig, wobei sich die Ellipsen 251 mit ihren langen Halbachsen alle entlang der Laserlinie 250 befinden. Die Ellipsen 251 überlappen sich dabei auf der Laserlinie 250. Jede einzelne Ellipse 251 entspricht im Querschnitt dabei einem durch eine asphärische Linse 231 des Mikrolinsenarrays 230 fokussiertem Laserlicht. Dabei muss nicht zwingend einer Ellipse 251 ein bestimmter Laser 210 zugeordnet sein. Die Breite der Laserlinie 250 ist sehr klein gegenüber der Länge der Laserlinie 250. Das Verhältnis beträgt bevorzugt mindestens 1 zu 100.

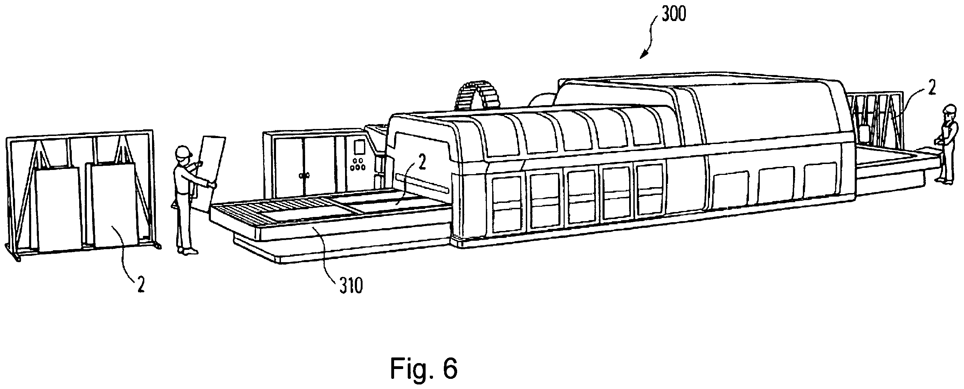

Die Fig. 6 zeigt einen Hochkonvektionsofen 300 als zweite Möglichkeit der Temperaturbehandlung im Verfahrensschritt II gemäß dem Hauptanspruch. Das beschichtete Substrat 2 wird in Form von rechteckigen Platten auf Laufwalzen 310 oder Laufbändern 310 dem Hochkonvektionsofen 300 mit konstanter geradliniger Geschwindigkeit $v_{IIb}$ zugeführt. Durch Konvektion wird die Substratschicht 3 des Substrats 5 auf eine bestimmte Temperatur $T_{IIb}$ erhitzt. Die Temperatur $T_{IIb}$ wirkt auf den Substratkörper 2 für eine bestimmte Zeit $\Delta t$ ein. Der erhitzte Substratkörper 2 verlässt daraufhin den Hochkonvektionsofen 300.

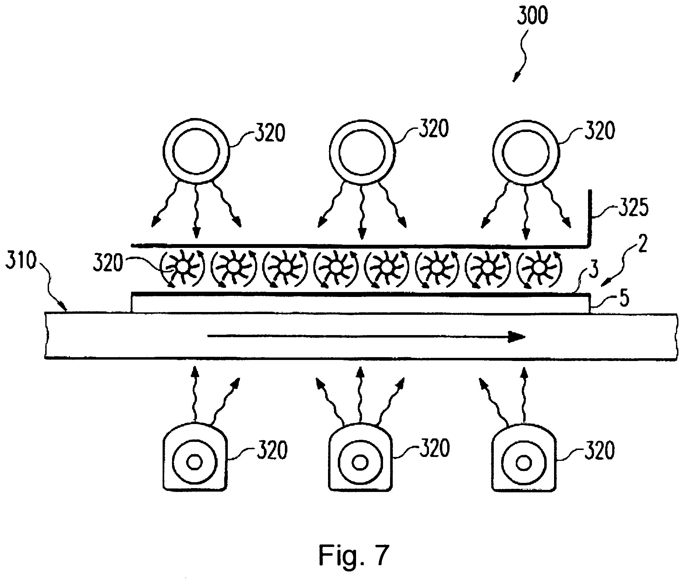

Fig. 7 zeigt den Verfahrensschritt II im Hochkonvektionsofen 300 näher. Der mit konstanter Geschwindigkeit $v_{IIb}$ auf einer Transporteinrichtung 310, etwa einem Laufband oder Laufwalzen, bewegte Substratkörper 2 wird durch Heizstrahler 320 erhitzt. Mindestens ein Ventilator 330 sorgt für eine gleichmäßige Durchmischung der erhitzten Luft. Die Beschichtung 3 und das Substrat 5 werden durch die Konvektion auf eine bestimmte Temperatur $T_{IIb}$ aufgeheizt. Dabei verteilt ein Heizblech 325 die Heizstrahlung der Heizstrahler 320 gleichmäßig entlang der Laufrichtung und sorgt somit zusätzlich für eine homogene Erhitzung der Beschichtung 3.

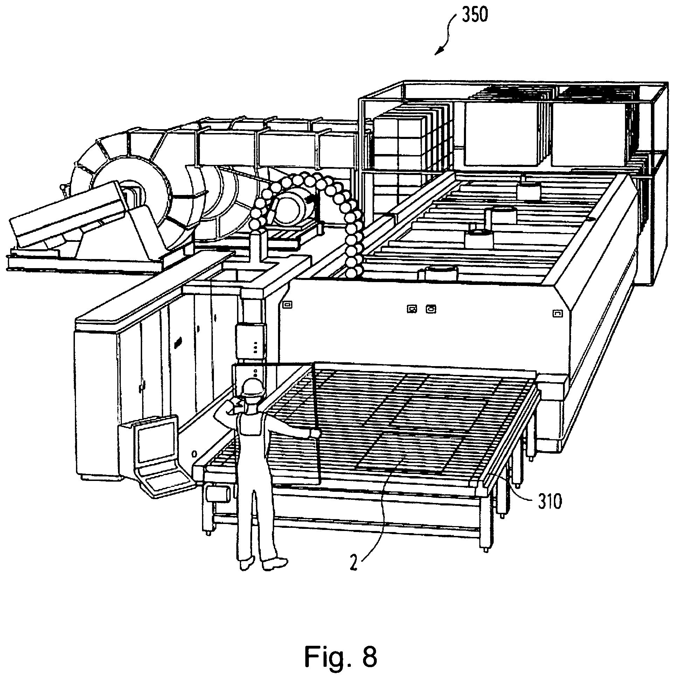

Die Fig. 8 zeigt einen Zweikammerofen 350 oder Mehrkammerofen oder Mehrzonenofen als weitere Möglichkeit der Temperaturbehandlung im Verfahrensschritt II. Das beschichtete Substrat 2 wird in Form von rechteckigen Platten auf Laufwalzen 310 oder Laufbändern 310 einer ersten Kammer des Zweikammeroffen 300 mit konstanter geradliniger Geschwindigkeit $v_{IIc}$ zugeführt. Durch Konvektion wird die Substratschicht 3 des Substrats 5 in der Zeit $\Delta t$ auf eine erste Temperatur gleichmäßig erhitzt. Danach wird der Substratkörper auf der Transporteinrichtung in eine zweite Kammer transportiert. In der zweiten Kammer wird der Substratkörper durch Konvektion und Strahlung in der Zeit $\Delta t$ auf eine zweite Temperatur gleichmäßig erhitzt.

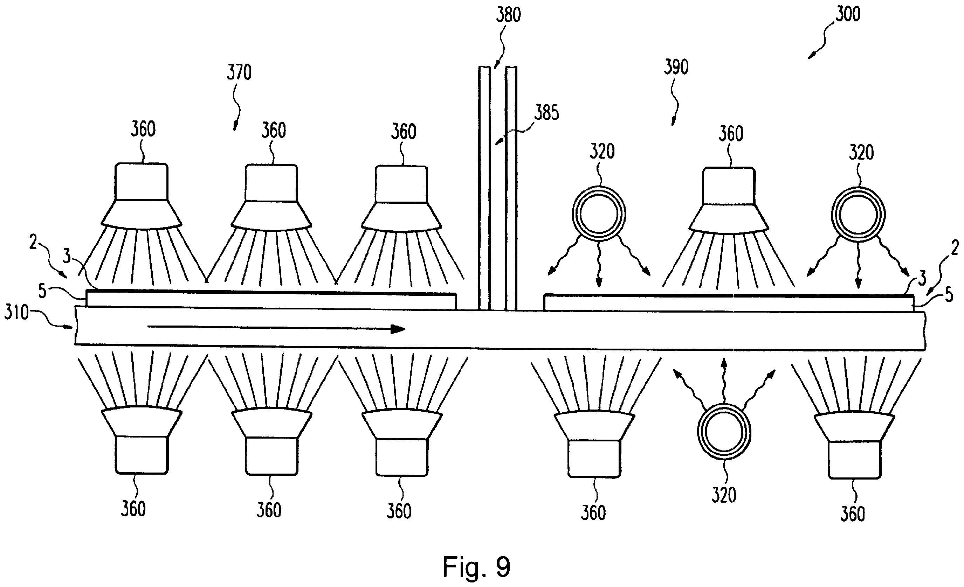

Fig. 9 zeigt den Verfahrensschritt II im Zweikammerofen 300 näher. Der mit konstanter Geschwindigkeit $v_{IIc}$ auf einer Transporteinrichtung 310, wie z.B. ein Laufband oder Laufwalzen, bewegte Substratkörper 2 wird in der ersten Kammer 370 durch mindestens ein Heißluftgebläse 360 gleichmäßig erhitzt. Die Beschichtung 3 und das Substrat 5 werden durch die Konvektion in der Zeit $\Delta t$ auf eine bestimmte Temperatur zwischen 350°C und 650°C aufgeheizt. Danach öffnet sich das Schott 380 und das Substrat gelangt in eine Schleusenklappe 385. Die Schleusenklappe trennt die erste Kammer 370 von der zweiten Kammer 390 zur thermischen Isolierung, denn in den Kammern 370 und 390 sollen unterschiedliche Temperaturen herrschen.

Danach wird das Substrat auf Laufwalzen in die zweite Kammer 390 des Zweikammerofens 350 geschickt. In der zweiten Kammer 390 wird das Substrat durch mindestens ein Heißluftgebläse 360 und mindestens einem Heizstrahler 320 in der Zeit $\Delta t$ auf eine Temperatur zwischen 350-700°C, bevorzugt zwischen 500°C und 650°C, gleichmäßig aufgeheizt. Der erhitzte Substratkörper 2 verlässt daraufhin den Zweikammerofen 300.

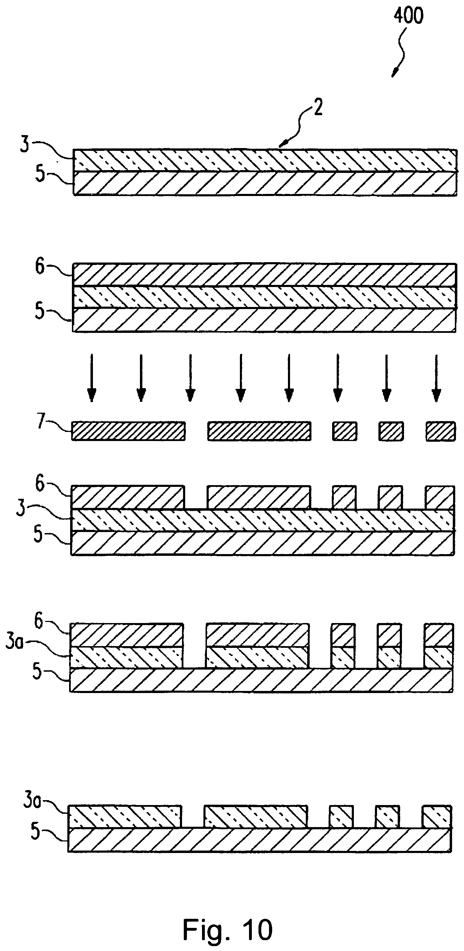

Fig. 10 zeigt ein Ätzverfahren nach einem Referenzverfahren in Teilschritten von oben nach unten. Der Substratkörper 2 ist im vorangegangenen Verfahrensschritt II temperaturbehandelt worden. Nun wird die Oberfläche des Substratkörpers 2 mit einer Säure, bevorzugt verdünnte Salzsäure, in Kontakt gebracht. Die Salzsäure ätzt homogen über das gesamte Substrat verteilt eine Aufrauhung in die Oberfläche. Die aufgeraute Oberfläche des Substrats hat nun das gewünschte optische Streuverhalten zum Beispiel für Dünnschicht-Solarzellen. Siehe dazu in Fig. 10 nur die oberste und die unterste der sechs Teilzeichnungen.

Im Referenzverfahren wird zur Erzeugung komplexerer Strukturen in die Oberfläche eines Substratkörpers 2, die Fotolithographie angewendet. Dabei wird zuerst auf die inzwischen abgekühlte Beschichtung 3 eine Fotoschicht 6 aufgetragen. Danach wird die Fotoschicht 6 durch eine Maske 7 hindurch belichtet, wodurch nur an den Stellen, an den die Maske 7 das Licht durchlässt, die Fotoschicht 6 auf der Beschichtung 3 verschwindet und diese dadurch wieder freilegt. Danach schließt sich das eigentliche Ätzen an, wobei bevorzugt verdünnte Salzsäure oder Flusssäure in die Beschichtung 3 eine Oberflächentextur 3a ätzt und zwar nur an den Stellen ohne Fotoschicht. Danach werden noch die Reste der Fotoschicht 6 entfernt. Bevorzugt wird auch das Ätzen III im Durchlaufverfahren durchgeführt. Siehe dazu alle sechs Teilzeichnungen in Fig. 10.

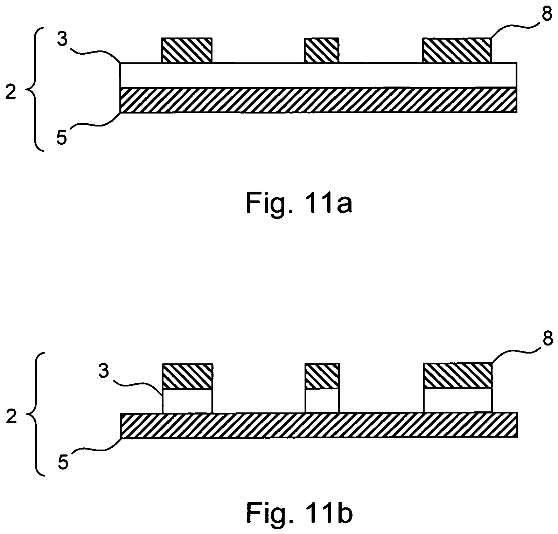

Fig. 11a und 11b zeigen das Ätzverfahren III, worin nach der Temperaturbehandlung II die Oberflächentextur 3a der Beschichtung 3 statistisch eingestellt wird. Hierbei wird in Fig. 11a das beschichtete Substrat 2 mit statistisch aufgebrachteter Maske 8 gezeigt. Fig. 11b zeigt das beschichtete Substrat 2 nach Durchführung des Ätzschritts.

Als besonders vorteilhaft stellt sich ein Ätzverfahren heraus, bei dem vor dem Ätzen eine Maske auf die Beschichtung durch Sputtern als nicht geschlossene Schicht oder in Inseln 8 aufgebracht wird. Beispielsweise können bei einem mit $ZnO_2$-Schicht 3 beschichteten Substrat 5 durch Sputtern Inseln 8 bzw. eine nicht geschlossene Schicht aus $SnO_2$ gebildet werden

Als zweite Methode des Ätzverfahrens wird vor dem Ätzen auf der Beschichtung unter Verwendung eines Komplexbildners eine Maske in situ erzeugt. Vorzugsweise wird als Komplexbildner hierbei mindestens ein Element aus der aus Oxalsäure, Malonsäure und Acetylaceton bestehenden Gruppe, vorzugsweise Oxalsäure oder Malonsäure eingesetzt. Auf diese Weise setzen sich unlösliche Metallkomplexsalze auf dem Substrat haufenförmig ab, wobei die Haufen auf der Oberfläche des Substrats als Inseln 8 statistisch verteilt sind. Beispielsweise bilden sich bei Verwendung von Zinkoxid als Substrat Zinkmalonat oder Zinkoxalat. Die Haufenbildung kann weiter verbessert werden, wenn gleichzeitig mit oder nach Zugabe des Komplexbildners Essigsäure eingesetzt wird. Auf diese Weise wird der Kontrast zwischen Metalloxidhaufen und Substrat schärfer, was zur Maskenbildung vorteilhaft ist.

Als dritte Methode des Ätzverfahrens wird vor dem Ätzen zur Erzeugung einer Maske ein nicht reaktives Pulver, vorzugsweise mindestens ein Element aus der aus $Al_2O_3$, $SiO_2$ und $BaSO_4$ bestehenden Gruppe auf die Beschichtung 3 mechanisch abgelegt, so dass sich hierdurch Inseln 8 bilden.

Als vierte Methode des Ätzverfahrens werden vor dem Ätzen zur Erzeugung einer Maske Oligomere, vorzugsweise Siloxanoligomere, auf die Beschichtung gestreut und selektiv angebunden, so dass sich Inseln 8 statistisch verteilt auf der Oberfläche der Beschichtung 3 bilden.

Vorzugsweise wird nach Erzeugung der Maske mit mindestens einer Broensted oder Lewissäure, vorzugsweise mit mindestens einem Element aus der aus Essigsäure, Zitronensäure, Ameisensäure, Eisentrichlorid, Aluminiumtrichlorid und Salzsäure bestehenden Gruppe, insbesondere bevorzugt mit Salzsäure geätzt. Fig. 11b zeigt das beschichtete Substrat 2 nach Durchführung des Ätzverfahrens. Anschließend kann, wie in der letzten Teilabbildung von Figur 10 gezeigt, die Maske wieder entfernt werden.

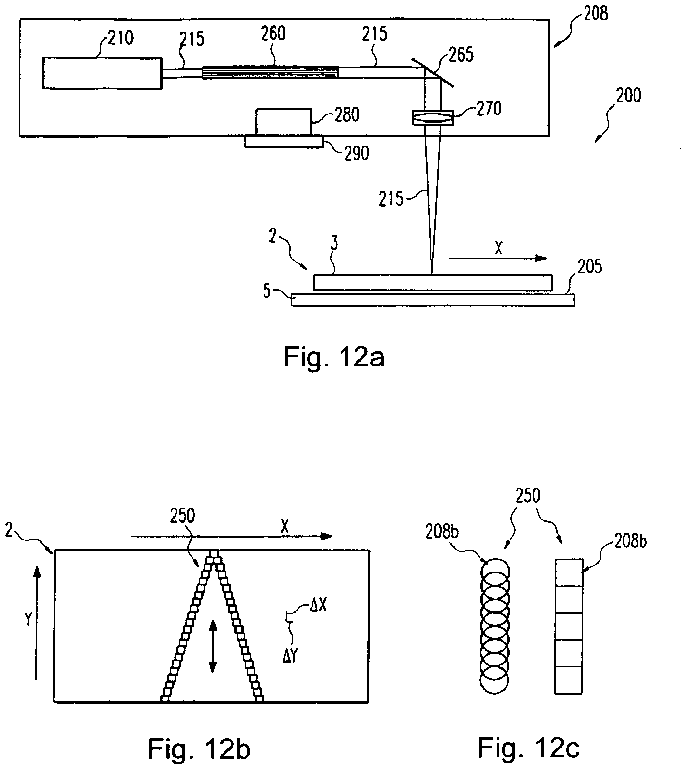

Die Figuren 12a, 12b und 12c zeigen eine alternative Temperaturbehandlung der Beschichtung 3 des Substratkörpers 2 mit einem gepulsten Yb:YAG/Scheibenlaser 210. Dies ist eine Alternative zu der Lasertemperaturbehandlung mit mehreren gekoppelten Lasern, die im ersten Ausführungsbeispiel beschrieben ist. Das Laserbeleuchtungsmodul 208 besteht hier aus einem Yb:YAG/Scheibenlaser 210, einer Glasfaseroptik 260, optional aus einem Umlenkspiegel 265, einem Fokussiermodul 270 und eine durch einen Motor 280 angetriebene Transporteinrichtung 290, die das Laserbeleuchtungsmodul 208 quer zur Bewegungsrichtung des Substratkörpers 2 gerade hin und her bewegt und so eine Laserlinie 250 auf der Substratoberfläche erzeugt. Siehe dazu Fig.12a und Fig.12b.

Der Yb:YAG/Scheibenlaser 210 ist ein Festkörperlaser, bei welchem das aktive Medium (der Laser-Kristall) die Form einer Scheibe hat. Der Laserstrahl 215 wird durch mehrfache Durchgänge einer Pumpstrahlung durch die Laserscheibe erzeugt. Einer der Resonatorspiegel ist an der Rückseite der Kristallscheibe aufgedampft, der andere Spiegel ist der Auskoppelspiegel und befindet sich in einiger Entfernung zur Scheibe. Vorteil dieser Form des Lasers ist die bessere Kühlung des Laserkristalls. Dieser ist mit der verspiegelten Fläche auf eine Wärmesenke geklebt und unterliegt wegen der Wärmeableitung über eine gesamte Grundfläche der Laserscheibe nur geringen mechanischen Spannungen, wodurch eine gute Fokussierbarkeit im Vergleich zu anderen Hochleistungs-Festkörperlasern erreicht wird. Typisches Kristallmaterial ist hoch Ytterbium-dotiertes YAG (Yttrium-Aluminium-Granat) beim sogenannten Yb:YAG-Laser mit einer Emissionswellenlänge von 1030 nm.

Zum Unterschied zu der in Fig.5a-b beschriebenen Erzeugung der Laserlinie 250, bei der die Laserlinie 250 durch mehrere Laser 210 gleichzeitig gebildet wird, wird hier die Laserlinie 250 durch einen Yb:YAG/Scheibenlaser 210 erzeugt, dessen gepulster Laserstrahl 215, der durch eine Glasfaseroptik 260, z.B. ein Laserlichtkabel, geführt wird, beispielsweise umgelenkt durch einen Spiegel 265 und fokussiert durch ein Fokussiermodul 270, senkrecht zur Bewegungsrichtung x, also in y-Richtung des Substratkörpers 2 über dessen gesamte Breite linear hin- und her- bewegt wird. Siehe dazu Fig. 12a und Fig. 12b. Die Bewegung des Laserbeleuchtungsmoduls 208 erfolgt in Fig. 12a senkrecht zur Zeichenebene durch eine mit einem Motor 280 angetriebene Transporteinrichtung 290, etwa einer Rollschiene.

Dabei kann der Beleuchtungsbereich 208b, d.h. der Laserstrahl-Fokus, auf der Substratoberfläche 3 kreisförmig oder rechteckig sein, wie in Fig.12c zu sehen ist. Ein kreisförmiger Laserstrahl-Fokus ist konventionell und daher leicht zu erzeugen, hat aber den Nachteil, dass man mit nebeneinandergesetzten Kreisen eine ebene Oberfläche nicht flächendeckend parkettieren kann. Es bleiben Lücken auf der Substratoberfläche. Um diese Lücken zu vermeiden, muss man in diesem Fall den Laserstrahl 215 so bewegen, dass sich die Kreise auf der Substratoberfläche überlappen und für eine möglichst gleichmäßige Abdeckung der Substratoberfläche sorgen. Siehe dazu die Fig. 12c.

Eine andere Möglichkeit ist es, den Laserstrahl 215 im Laserbeleuchtungsmodul 208 optisch so zu führen, dass der Laserstrahl-Fokus ein Rechteck bildet, womit eine lückenlose Überdeckung durch eine nahezu schachbrettartige Parkettierung der Beschichtung 3 möglich ist. Eine deckende Parkettierung mit Rechtecken kann schneller erfolgen als eine deckende Parkettierung (bei gleicher Scangeschwindigkeit) mit flächengleichen Kreisen, die ja zur Deckung erst noch überlappt werden müssen. Siehe auch dazu die Fig. 12c. Den rechteckigen Laserfokus kann man durch eine Führung des Laserstrahls 215 durch eine Glasfaseroptik 260 erzielen, deren Glasfasern am Ende einen rechteckigen Querschnitt aufweisen. Dieser im Querschnitt rechteckige Laserstrahl 215 kann dabei umgelenkt werden durch einen Spiegel 265 und fokussiert werden durch ein Fokussiermodul 270. Siehe dazu Fig. 12a.

Da die mittlere Scangeschwindigkeit $v_{scan}$ des Yb:YAG/Scheibenlasers 210 und die dazu senkrecht gerichtete Transportgeschwindigkeit $v_{substrat}$ des Substratkörpers 2 sich überlagern, erzeugt der Laserstrahl 215 auf der Oberfläche des Substratkörpers 2 genaugenommen eine Zickzacklinie 250, wie in Fig. 12b zu sehen ist. Wenn die mittlere Scangeschwindigkeit $v_{scan}$ des Yb:YAG/Scheibenlasers hinreichend groß gegenüber der Transportgeschwindigkeit $v_{substrat}$ des Substratkörpers ist, wird die Parkettierung deckend. Der Laserstrahl 215 scannt in der Zeit $T_s$ mit der mittleren Scangeschwindigkeit $v_{scan}$ die Breite $B$ in y-Richtung des Substratkörpers 2 bei der Hin und Her-Bewegung zweimal ab. Somit gilt $T_s = 2B/v_{scan}$ In dieser Zeit $T_s$, in der sich das Laserbeleuchtungsmodul 208 in y-Richtung einmal hin und her bewegt hat, muss sich der Substratkörper 2 in der x-Richtung gerade um die Länge Δx des rechteckigen Laserfokus bewegt haben, damit die Parkettierung deckend wird:

$$\Delta x = v_{substrat} T_s = v_{substrat} 2B / v_{scan} \ .$$

Folglich gilt

$$v_{scan} = \frac{2B}{\Delta x} \cdot v_{substrat} \ ,$$

Sind also die Geschwindigkeiten $v_{scan}$ und $v_{substrat}$ nach dieser Gleichung aufeinander abgestimmt, scannt das Laserbeleuchtungsmodul 208 die gesamte Oberfläche des Substratkörpers 2 zeilenweise deckend ab und kann damit die Beschichtung 3 des Substratkörpers 2 homogen erwärmen. Die Rechtecke überlappen sich allerdings dabei. Es ist aber auch denkbar, dass, solange das Laserbeleuchtungsmodul 208 eine Zeile des Substratkörpers 2 abscannt, die Transporteinrichtung 205 den Substratkörper 2 anhält und ihn nur zwischen den zeilenweisen Scans um die Einheit Δx weiterbewegt. Somit wird eine Zickzackbewegung auf jeden Fall ausgeschlossen, und die Rechtecke überlappen sich nicht.

Im Folgenden wird ein erstes Ausführungsbeispiel des Verfahrens anhand der Figuren ausführlich beschrieben.

Ein Substrat 5, vorzugsweise aus Glas, wird im Verfahrensschritt I mit einem leitfähigen, transparenten Metalloxid beschichtet, welches im Wesentlichen aus Zinkoxid, Cadmiumoxid, Zinnoxid, Indiumoxid oder aus Mischungen von zwei oder mehreren dieser Oxide besteht.

Beschichtet wird mit einer Beschichtungsvorrichtung 100, siehe Fig. 2, die das Metalloxid mittels physikalischer oder chemischer Gasphasenabscheidung in einem Vakuumprozess auf dem Substrat 5 abscheidet. Die Beschichtung wird bei kleinen Substrattemperaturen $T_I$ vorgenommen. Die Substrate 5 werden dabei bevorzugt während oder vor der Beschichtung nicht gesondert beheizt. Die Abscheidung der transparenten leitfähigen Schicht 2 erfolgt in einem Vakuumprozess mittels physikalischer Gasphasenabscheidung durch Sputtern oder reaktives Sputtern oder durch Verdampfen oder durch thermisches Verdampfen oder durch Elektronenstrahlverdampfen oder durch Laserstrahlverdampfen.

Die Abscheidung der transparenten leitfähigen Schicht 3 kann in einem Vakuumprozess auch chemisch oder speziell durch thermisch aktivierte chemische oder durch plasmaaktivierte chemische oder durch laseraktivierte Gasphasenabscheidung erfolgen. Auch kann bei der Abscheidung der transparenten leitfähigen Schicht 3 die chemische Gasphasenabscheidung oder die thermisch aktivierte chemische Gasphasenabscheidung in einzelnen, jeweils nur aus einer der konstituierenden Komponenten bestehenden und maximal eine Monolage umfassenden Teilschichten erfolgen.

Als dritte Möglichkeit kann die Abscheidung der transparenten leitfähigen Schicht(en) 3 nasschemisch, z.B. durch ein Sol-Gel Verfahren oder durch ein Druckverfahren erfolgen. Ausführlich beschrieben wird hier in diesem ersten Ausführungsbeispiel das Sputtern, wie in Fig. 2 gezeigt ist. Einem Festkörper 3', der aus einem transparenten, leitfähigen Metalloxid besteht, werden in einer Vakuumkammer 101 durch Beschuss mit energiereichen Ionen 109 Atome 110 herausgelöst. Diese Atome scheiden sich an der Oberfläche eines Substrats 5, das in einem Durchlaufverfahren mit konstanter Geschwindigkeit $v_I$ auf einer Transporteinrichtung 120 durch die Vakuumkammer 101 bewegt wird, ab.

Die Abscheidung der transparenten leitfähigen Schicht 3 erfolgt bevorzugt bei einer Substrattemperatur $T_I$, die höchstens 180°C, weiter bevorzugt höchstens 160°C, noch weiter bevorzugt höchstens 150°C, insbesondere bevorzugt höchstens 130°C beträgt. Der so mit der Beschichtung 3 beschichtete Substratkörper 2 verlässt auf der Transporteinrichtung 120 die Sputteranlage 100. Bevorzugt wird das Substrat nicht eigens vorgeheizt, sondern die Abscheidung erfolgt anfangs auf dem sich auf Raumtemperatur befindlichen Substrat. Durch das Beschichten erhöht sich die Temperatur des Substrats gleichmäßig, bis sich durch Konvektion und Abstrahlungsverluste ein thermisches Gleichgewicht einstellt. Im thermischen Gleichgewicht ergibt sich bevorzugt die vorstehend genannte Temperatur.

Im nächsten optionalen Verfahrensschritt II zur Einstellung der elektrischen Leitfähigkeit und optischen Transmission wird das beschichtete Substrat 2 einer Temperaturbehandlung durch Laserbestrahlung, auch Lasertempern genannt, unterzogen. Die Beschichtung 3 wird durch das Lasertempern dabei auf eine Temperatur $T_{IIa}$ von z.B. 200°C erhitzt. Das Lasertempern erfolgt fast senkrecht zur ebenen Oberfläche der Beschichtung 3 des Substratkörpers 2. Wie in Fig. 4c gezeigt ist, ist der Laserstrahl gegen die Senkrechte der Oberfläche um einen kleinen Winkel δ geneigt, um die Laser 210 vor seinem eigenen emittierten Licht durch die Reflexion an der Beschichtung 3 zu schützen. Das von vielen Einzellasern 210 erzeugte Laserlicht wird durch Kollimatoren 220 und anschließend durch asphärische Linsen 231 geleitet. Dabei bilden mindestens zwei Laser 210, ein Kollimator 220 mit Zylinderlinsen 221 und ein sogenanntes Mikrolinsenarray 230 mit asphärischen Linsen 231 je ein Laserbeleuchtungsmodul 208, wie es in der Figur 5a näher beschrieben ist. Die asphärischen Linsen 231 des Mikrolinsenarrays 230 fokussieren das durch die Kollimatoren 230 parallelisierte Laserlicht, so dass jeder einzelne Strahl einen Strahlkegel 240 erzeugt, der im Fokus einen elliptischen Querschnitt aufweist. Die langen Hauptachsen der Ellipsen 251 dieser Strahlkegel 240 befinden sich alle auf einer geraden Linie, einer sogenannten Laserlinie 250. Die lineare Leitungsdichte $P_{lin}$ dieser Laserlinie 250 beträgt z.B. 450 Watt/cm. Dabei überlappen sich diese Ellipsen 251 in Richtung ihrer längeren Halbachse, wie es in Fig. 5b dargestellt ist. Die Ellipsen 251, insbesondere die Länge der beiden kurzen Halbachsen, sind klein gegen die Länge der Laserlinie 250. Das Verhältnis von der Länge zur Breite der Laserlinie 250, wobei die Breite durch die kurzen Halbachsen der Ellipsen 251 bestimmt ist, ist dabei vorteilhafterweise größer als 100. Somit kann eine starke Fokussierung erzielt werden.

Jedes einzelne Laserbeleuchtungsmodul 208 erzeugt eine Laserline 250. Um aber das beschichtete Substrat 2 in seiner ganzen Breite gleichmäßig zu bestrahlen, werden die Laserbeleuchtungsmodule 208 so ausgerichtet, dass sie eine gemeinsame Laserlinie 250 auf der Beschichtung 3 abbilden. Dabei können sich die einzelnen Beleuchtungsbereiche 208b, die jeweils von einem Laserbeleuchtungsmodul 208 erzeugt werden, zu einer gemeinsamen Laserlinie 250 überlappen, oder die einzelnen Beleuchtungsbereiche 208b sind in mehreren Streifen nebeneinander geordnet und bilden so eine gemeinsame Laserlinie 250.

Vorteilhaft wird dabei das Durchgangsverfahren angewendet, in dem das beschichtete Substrat 2 auf einer Transporteinrichtung 205 mit konstanter Geschwindigkeit $v_{IIa}$ geradlinig bewegt wird und die Laserbeleuchtungsmodule 208 stationär angeordnet sind. Die Substratbreite beträgt dabei zwischen 1m und 6m. Die Laserlinie 250 überstreicht die gesamte Breite des Substrats senkrecht zur Bewegungsrichtung, da die Beleuchtungsbereiche 208b entsprechend nebeneinander angeordnet sind.

Bei dieser Temperaturbehandlung durch Laserstrahlen werden ca. 10-20% der Strahlungsenergie des Laserlichts in die Schicht 3 eingekoppelt.

Das Tempern durch Laserbestrahlung erfolgt bevorzugt in einem Wellenlängenbereich von 800nm bis 1200nm. Beim Tempern durch Laserbestrahlung werden für das erfindungsgemäße Verfahren im Wellenlängenbereich von 800nm bis 1000nm bevorzugt Dioden-Laser insbesondere mit einer Wellenlänge von 808nm bzw. 950nm und im Wellenlängenbereich von 1000nm bis 1200nm Festkörperlaser eingesetzt. Für die Wellenlänge 950nm sind zum Beispiel InGaAs-Dioden-Laser geeignet. Laserdioden sind sehr klein und erfordern nur wenig Aufwand beim Betrieb. Eine nützliche Eigenschaft von Laserdioden ist ihre hohe Modulationsbandbreite. Durch Modulation des elektrischen Stromes, der durch die Diode fließt, kann man eine nahezu lineare Änderung der Ausgangsleistung erreichen. Diodenlaser sind die effizientesten Strahlungsquellen im nahen Infrarotbereich und haben Wirkungsgrade bis über 50%.

Betrachtet man das Reflexionsspektrum einer TCO-Schicht, so stellt man fest, dass an der Plasmakante, die definitionsgemäß eine charakteristische Struktur in einem Reflexionsspektrum ist, die Absorption mit steigender Wellenlänge zunimmt, die Eindringtiefe nimmt hingegen ab. Die Plasmakante tritt bei Festkörpern an der Stelle im Spektrum auf, wo die Plasmaresonanz auftritt. Dort weist der Realteil $\varepsilon 1$ der Dielektrizitätskonstanten eine Nullstelle auf. Bei $\varepsilon 1=1$ verschwindet die Reflexion. Bei ca. 1000nm ist die Absorption jedoch relativ gering. Um aber die Laserleistung effektiv zu nutzen, werden daher im Wellenlängenbereich von 1000nm bis 1200nm, insbesondere Nd:YAG-Laser oder Yb:YAG-Laser eingesetzt.

Ein Nd:YAG-Laser bzw. Yb:YAG-Laser ist ein Festkörperlaser, der als aktives Medium einen Neodym- bzw. einen Yttrium YAG-Kristall verwendet. Nd:YAG steht für Neodym-dotierter Yttrium-Aluminium-Granat-Laser. Der Nd:YAG-Laser emittiert im Infrarotbereich mit der Wellenlänge 1064 nm. Der Yb:YAG-Laser ist ein Ytterbiumdotierter Yttrium-Aluminium-Granat-Laser. Der Yb:YAG-Laser strahlt mit einer Wellenlänge von 1030 nm. Dieser Yb:YAG-Laser wird jedoch bevorzugt im gepulsten Scanmodus eingesetzt. Siehe dazu Figur 11a-c, welche eine alternative Laser-Temperaturbehandlung durch einen YB:YAG/Scheibenlaser beschreibt. Alternativ eignet sich auch ein Er:YAG-Laser, Ho-YAG-Laser oder $CO_2$-Laser. Alle Laser können gepulst oder kontinuierlich betrieben werden. Die Festkörperlaser können als Stab oder Scheibe oder als Faser ausgeführt werden.

Nach dem Lasertempern folgt der Verfahrensschritt III. Das inzwischen abgekühlte beschichtete Substrat 2 wird nun in einer Ätzvorrichtung 400 geätzt. Dazu ist der Ablauf der Ätzung in Fig. 8 dargestellt. Dieser optionale Ätzschritt III kann nur erfolgen, wenn die Dichte $\delta$ der Beschichtung 3 durch die Temperaturbehandlung II einen bestimmten Wert erlangt hat. Durch die Ätzung wird der dritte gewünschte Parameter eingestellt: Das optische Streuverhalten der Beschichtung 3. Dazu wird durch eine Behandlung bevorzugt mit verdünnter Salzsäure (0,1% bis 5%) eine bestimmte Oberflächentextur geätzt. Das Ätzen wird dabei bevorzugt in einem Durchlaufverfahren durchgeführt, bei dem die Ätzvorrichtung ortsfest ist und das beschichte Substrat 2 mit konstanter Geschwindigkeit $v_{III}$ durch diese Ätzvorrichtung 400 hindurch bewegt wird.

Im Folgenden wird ein zweites Ausführungsbeispiel anhand der Figuren ausführlich beschrieben. In diesem zweiten Ausführungsbeispiel entspricht der Verfahrensschritt I dem aus dem ersten Ausführungsbeispiel, der hier nicht wiederholt beschrieben wird. Im Verfahrensschritt II dieses zweiten Ausführungsbeispiels ist die Temperaturbehandlungsvorrichtung ein Hochkonvektionsofen 300. In diesem Hochkonvektionsofen 300 wird das beschichtete Substrat 2 im Wesentlichen durch Konvektion gleichmäßig erhitzt, um die gewünschten beiden Parameter elektrische Leitfähigkeit und optische Transmission einzustellen.

Der Substratkörper 2, ein beschichtetes Glas, fährt auf einem Förderband 310 oder auf Walzrollen 310 mit konstanter Geschwindigkeit $v_{IIb}$ durch den Hochkonvektionsofen 300. Die durch Heizstrahler 320 erhitzte Luft heizt die Beschichtung 3 auf, kühlt durch die Wärmeübertragung auf die Beschichtung 3 deswegen etwas ab, wird durch Ventilatoren 330 nach oben gewirbelt, die auch dafür sorgen, dass neue heiße Luft auf die Beschichtung 3 zu nach unten gewirbelt wird. Siehe dazu die Figur 7.

Angetrieben durch Ventilatoren 330 wird die Konvektion so gleichmäßig in Gang gehalten, und somit wird die Beschichtung gleichmäßig erhitzt z.B. auf die Temperatur $T_{IIb}$= 200°C. Die Ventilatoren 330 können dabei, wie in der Fig. 7 gezeigt ist, in Reihen entlang der Laufrichtung der Transporteinrichtung 310 angeordnet sein, wobei jeweils zwei benachbarte Ventilatoren 330 gegensinnig rotieren, so dass sich vorteilhaft die auf- und absteigenden Konvektionsströme sich jeweils gegenseitig verstärken. Die Wärmeübertragung geschieht dabei nicht nur durch Konvektion, also durch den Transport von Teilchen, sondern auch direkt durch Strahlung und durch Wärmeleitung durch das Substrat 5. Den größten Anteil an der Erwärmung der Beschichtung 3 hat dabei die Konvektion, wohingegen die Anteile von Strahlung und Wärmeleitung wesentlich geringer sind. Auf der Oberseite des Substratkörpers 2 wird ein Teil der Wärme von der Beschichtung durch Strahlung und Konvektion absorbiert, ein Teil der Strahlung und Konvektion wird reflektiert und ein Teil der Strahlung und Konvektion wird durchgelassen (Transmission). Auf der Unterseite des Substratkörpers 2 geht ein Teil der Wärme durch das Substrat 5 und erreicht so durch Wärmeleitung von unten die Beschichtung 3.

Wie anhand der Figuren 8 und 9 beschrieben, kann alternativ die Erhitzung des Substratkörpers 5 durch Strahlung und Konvektion auch in einem Zweikammerofen 350 durchgeführt werden. Im Zweikammeroffen 350 werden neben Heizstrahlern 320 auch Heißluftgebläse 360 eingesetzt, die den Substratkörper 2 durch Konvektion gleichmäßig aufheizen.

Die beiden einzustellenden physikalischen Größen der elektrischen Leitfähigkeit und optischen Transmission können durch die Temperatur $T_{IIb}$ und die Dauer $\Delta t_{IIb}$ der Temperaturbehandlung beeinflusst werden. Diesem Verfahrensschritt II schließt sich ein Ätzschritt III an, der im ersten Ausführungsbeispiel beschrieben ist.

Durch die Laserbestrahlung, wie sie im ersten Ausführungsbeispiel beschrieben worden ist, oder die Temperaturbehandlung in einem Hochkonvektionsofen bzw. Zweikammerofen, wie sie im zweiten Ausführungsbeispiel beschrieben ist, werden die elektrische und die optische Leitfähigkeit erheblich verbessert, wobei mit dem Lasertempern die besten Ergebnisse erzielt werden.

Man kann mit diesen beiden Temperaturbehandlungen (II) einen spezifischen Widerstand von $100\mu\Omega$cm bis $1.000\mu\Omega$cm, bevorzugt von $200\mu\Omega$cm bis $750\mu\Omega$cm, eine Elektronenkonzentration von $2\times10^{20}$cm$^{-3}$ bis $8\times10^{20}$cm$^{-3}$, sowie eine Ladungsträgerbeweglichkeit zwischen 10 cm$^2$/Vs und 75 cm$^2$/Vs, bevorzugt zwischen 20 cm$^2$/Vs und 45 cm$^2$/Vs erzielen.

Alle beschriebenen und/oder gezeichneten Merkmale können im Rahmen der Erfindung vorteilhaft miteinander kombiniert werden. Die Erfindung ist nicht auf die Ausführungsbeispiele beschränkt.

## Patentansprüche

1. Verfahren zur Herstellung eines beschichteten Gegenstands (2) durch Abscheidung (I) mindestens einer transparenten leitfähigen Metalloxidschicht (3) auf einem Substrat (5),
   wobei eine Oberflächentextur (3a) der Metalloxidschicht (3) durch ein Ätzverfahren (III) eingestellt wird,
   **dadurch gekennzeichnet,**
   **dass** vor dem Ätzen auf der Schicht (3) unter Verwendung eines Komplexbildners eine Maske in situ erzeugt wird, wobei sich unlösliche Metallkomplexsalze auf dem Substrat haufenförmig absetzen und die Haufen auf der Oberfläche des Substrats statistisch verteilt sind.

2. Verfahren nach Anspruch 1,
   **dadurch gekennzeichnet,**
   **dass** nach der Abscheidung (I) eine Temperaturbehandlung (II) der Schicht (3) erfolgt, wobei das Ätzverfahren (III) nach der Temperaturbehandlung (II) durchgeführt wird.

3. Verfahren nach Anspruch 1,
   **dadurch gekennzeichnet,**
   **dass** die Maske durch ein nasschemisches Tauch- oder Sprühverfahren, erzeugt wird.

4. Verfahren nach Anspruch 1,
   **dadurch gekennzeichnet,**
   **dass** gleichzeitig mit oder nach Zugabe des Komplexbildners eine nicht-komplexbildende Säure eingesetzt wird.

5. Verfahren nach Anspruch 4,

**dadurch gekennzeichnet,**
**dass** als nicht-komplexbildende Säure eine Monocarbonsäure oder eine Essigsäure eingesetzt wird.

6. Verfahren nach einem der Ansprüche 1 bis 5,
   **dadurch gekennzeichnet,**
   **dass** nach Erzeugung der Maske mit mindestens einem Element aus der aus Essigsäure, Zitronensäure, Ameisensäure, Eisentrichlorid, Aluminiumtrichlorid und Salzsäure bestehenden Gruppe geätzt wird.

7. Verfahren nach einem der Ansprüche 1 bis 6,
   **dadurch gekennzeichnet,**
   **dass** die Schicht (3) aus ZnOy, wobei O<y<l ist, hergestellt wird.

8. Verfahren nach Anspruch 7,
   **dadurch gekennzeichnet,**
   **dass** die Schicht (3) mit bis zu 2at% Al bezogen auf Zn dotiertem ZnOy hergestellt wird.

9. Verfahren nach einem der Ansprüche 1 bis 8,
   **dadurch gekennzeichnet,**
   **dass** das Einstellen der Oberflächentextur (3a) durch einen Ätzschritt (III) in einem Durchlaufverfahren erfolgt.

10. Verfahren nach Anspruch 2,
    **dadurch gekennzeichnet,**
    **dass** die Temperaturbehandlung (II) in einem Durchlaufprozess erfolgt.

11. Verfahren nach einem der Ansprüche 1 bis 10,
    **dadurch gekennzeichnet,**
    **dass** zwischen Substrat (5) und leitfähiger Schicht (3) eine Diffusionssperre (4) eingefügt wird.

12. Verfahren nach einem der Ansprüche 1 bis 11,
    **dadurch gekennzeichnet,**
    **dass** zwischen Substrat (5) und leitfähiger Schicht (3) oder Substrat (5) und Diffusionssperre (4) eine optische Interferenzschicht (4a, 4b) zur Interferenzentspiegelung eingefügt wird.

13. Verfahren nach Anspruch 11 oder 12,
    **dadurch gekennzeichnet,**
    **dass** die Diffusionssperre (4) selbst als optische Interferenzschicht (4a, 4b) ausgebildet wird.

14. Verfahren nach einem der Ansprüche 1 bis 13,
    **dadurch gekennzeichnet,**
    **dass** die Abscheidung (I) der transparenten leitfähigen Schicht (3) durch Sputtern oder durch Verdampfen, insbesondere durch thermisches Verdampfen oder durch Elektronenstrahlverdampfen oder durch Laserstrahlverdampfen, erfolgt.

15. Verfahren nach einem der Ansprüche 1 bis 14,
    **dadurch gekennzeichnet,**
    **dass** die Abscheidung (I) der transparenten leitfähigen Schicht (3) durch chemische, insbesondere durch thermisch aktivierte chemische Gasphasenabscheidung, erfolgt.

16. Verfahren nach Anspruch 15,
    **dadurch gekennzeichnet,**
    **dass** die Abscheidung (I) der transparenten leitfähigen Schicht (3) in einzelnen, jeweils nur aus einer der konstituierenden Komponenten bestehenden und maximal eine Monolage umfassenden Teilschichten erfolgt.

17. Verfahren nach Anspruch 16,
    **dadurch gekennzeichnet,**
    **dass** die Abscheidung (I) der transparenten leitfähigen Schicht (3) durch plasmaaktivierte chemische oder durch laseraktivierte chemische Gasphasenabscheidung erfolgt.

**18.** Verfahren nach einem der Ansprüche 1 bis 17,
**dadurch gekennzeichnet,**
**dass** die Abscheidung (I) der transparenten leitfähigen Schicht (3) durch ein Sol-Gel Verfahren oder durch ein Druckverfahren erfolgt.

## Claims

**1.** Process for the production of a coated article (2) via deposition (I) of at least one transparent conductive metal oxide layer (3) on a substrate (5),
where a surface texture (3a) of the metal oxide layer (3) is established via an etching process (III), **characterized in that**
before the etching on the layer (3) with use of a complexing agent a mask is produced in situ, where insoluble metal complex salts are deposited in the form of discrete accumulations on the substrate and the discrete accumulations are randomly distributed on the surface of the substrate.

**2.** Process according to Claim 1,
**characterized in that**
after the deposition (I) the layer (3) is subjected to a heat treatment (II), where the etching process (III) is carried out after the heat treatment (II).

**3.** Process according to Claim 1,
**characterized in that**
the mask is produced via a wet chemical immersion or spray process.

**4.** Process according to Claim 1,
**characterized in that**
a non-complexing acid is used at the same time as or after addition of the complexing agent.

**5.** Process according to Claim 4,
**characterized in that**
non-complexing acid used comprises a monocarboxylic acid or an acetic acid.

**6.** Process according to any of Claims 1 to 5, **characterized in that**
etching is carried out after production of the mask with at least one member of the group consisting of acetic acid, citric acid, formic acid, iron trichloride, aluminium trichloride and hydrochloric acid.

**7.** Process according to any of Claims 1 to 6,
**characterized in that**
the layer (3) is produced from ZnOy, where O < y < 1.

**8.** Process according to Claim 7,
**characterized in that**
the layer (3) is produced ZnOy doped with up to 2 at% of Al, based on Zn.

**9.** Process according to any of Claims 1 to 8,
**characterized in that**
the surface texture (3a) is established in an etching step (III) in a continuous process.

**10.** Process according to Claim 2,
**characterized in that**
the heat treatment (II) takes place in a continuous procedure.

**11.** Process according to any of Claims 1 to 10,
**characterized in that**
a diffusion barrier (4) is inserted between substrate (5) and conductive layer (3).

**12.** Process according to any of Claims 1 to 11,

**characterized in that**
antireflective interference is provided by introducing an optical interference layer (4a, 4b) between substrate (5) and conductive layer (3) or substrate (5) and diffusion barrier (4).

13. Process according to Claim 11 or 12,
**characterized in that**
the diffusion barrier (4) is itself configured as optical interference layer (4a, 4b).

14. Process according to any of Claims 1 to 13,
**characterized in that**
the deposition (I) of the transparent conductive layer (3) takes place via sputtering or via vaporization, in particular via thermal vaporization or via electron-beam vaporization or via laser-beam vaporization.

15. Process according to any of Claims 1 to 14,
**characterized in that**
the deposition (I) of the transparent conductive layer (3) takes place via chemical, in particular via thermally activated chemical, gas-phase deposition.

16. Process according to Claim 15,
**characterized in that**
the deposition (I) of the transparent conductive layer (3) takes place in individual sublayers, in each case made of only one of the constituent components and comprising at most a monolayer.

17. Process according to Claim 16,
**characterized in that**
the deposition (I) of the transparent conductive layer (3) takes place via plasma-activated chemical gas-phase deposition or via laser-activated chemical gas-phase deposition.

18. Process according to any of Claims 1 to 17,
**characterized in that**
the deposition (I) of the transparent conductive layer (3) takes place via a sol-gel process or via a printing process.


**Revendications**

1. Procédé pour la production d'un objet revêtu (2) par dépôt (I) d'au moins une couche d'oxyde métallique conductrice transparente (3) sur un substrat (5),
où une texture superficielle (3a) de la couche d'oxyde métallique (3) est établie par un procédé de gravure (III),
**caractérisé en ce que**, avant la gravure, un masque est formé in situ sur la couche (3) au moyen d'un complexant,
où des sels complexes métalliques insolubles se déposent sous forme d'amas sur le substrat et les amas sont répartis statistiquement sur la surface du substrat.

2. Procédé selon la revendication 1,
**caractérisé en ce que**, après le dépôt (I), a lieu un traitement thermique (II) de la couche (3), où le procédé de gravure (III) est mis en œuvre après le traitement thermique (II).

3. Procédé selon la revendication 1,
**caractérisé en ce que** le masque est produit par un procédé d'immersion ou de pulvérisation chimique humide.

4. Procédé selon la revendication 1,
**caractérisé en ce que**, en même temps que ou après l'addition du complexant, un acide non complexant est utilisé.

5. Procédé selon la revendication 4,
**caractérisé en ce qu'**un acide monocarboxylique ou un acide acétique est utilisé comme acide non complexant.

6. Procédé selon l'une des revendications 1 à 5,
**caractérisé en ce que**, après la formation du masque, on grave avec au moins un élément du groupe consistant en l'acide acétique, l'acide citrique, l'acide formique, le trichlorure de fer, le trichlorure d'aluminium et l'acide chlorhydrique.

**7.** Procédé selon l'une des revendications 1 à 6,
**caractérisé en ce que** la couche (3) est produite à partir de ZnOy, où 0 < y < 1.

**8.** Procédé selon la revendication 7,
**caractérisé en ce que** la couche (3) est produite avec ZnOy dopé avec jusqu'à 2 at% de Al par rapport à Zn.

**9.** Procédé selon l'une des revendications 1 à 8,
**caractérisé en ce que** l'établissement de la texture superficielle (3a) a lieu par une étape de gravure (III) dans un procédé continu.

**10.** Procédé selon la revendication 2,
**caractérisé en ce que** le traitement thermique (II) a lieu dans un processus continu.

**11.** Procédé selon l'une des revendications 1 à 10,
**caractérisé en ce qu'**une barrière de diffusion (4) est insérée entre le substrat (5) et la couche conductrice (3).

**12.** Procédé selon l'une des revendications 1 à 11,
**caractérisé en ce qu'**une couche d'interférence optique (4a, 4b) est insérée entre le substrat (5) et la couche conductrice (3) ou le substrat (5) et la barrière de diffusion (4) pour un traitement antireflet par interférence.

**13.** Procédé selon la revendication 11 ou 12,
**caractérisé en ce que** la barrière de diffusion (4) est formée elle-même comme couche d'interférence optique (4a, 4b).

**14.** Procédé selon l'une des revendications 1 à 13,
**caractérisé en ce que** le dépôt (I) de la couche conductrice transparente (3) a lieu par pulvérisation cathodique ou par évaporation, en particulier par évaporation thermique ou par évaporation par faisceau d'électrons ou par évaporation par faisceau laser.

**15.** Procédé selon l'une des revendications 1 à 14,
**caractérisé en ce que** le dépôt (I) de la couche conductrice transparente (3) a lieu par dépôt chimique en phase vapeur, en particulier par dépôt chimique en phase vapeur activé thermiquement.

**16.** Procédé selon la revendication 15,
**caractérisé en ce que** le dépôt (I) de la couche conductrice transparente (3) a lieu en couches partielles individuelles, chacune ne consistant qu'en l'un des composants constitutifs et comprenant au maximum une monocouche.

**17.** Procédé selon la revendication 16,
**caractérisé en ce que** le dépôt (I) de la couche conductrice transparente (3) a lieu par dépôt chimique en phase vapeur activé par plasma ou par dépôt chimique en phase vapeur activé par laser.

**18.** Procédé selon l'une des revendications 1 à 17,
**caractérisé en ce que** le dépôt (I) de la couche conductrice transparente (3) a lieu par un procédé sol-gel ou par un procédé d'impression.

Fig. 1

EP 2 529 406 B1

Fig. 2

Fig. 3

Fig. 4a

Fig. 4b

Fig. 4c

Fig. 5a

Fig. 5b

Fig. 6

EP 2 529 406 B1

Fig. 7

Fig. 8

Fig. 9

Fig. 10

Fig. 11a

Fig. 11b

Fig. 12a

Fig. 12b

Fig. 12c

**EP 2 529 406 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2007018975 A1
- WO 2009019376 A2

- US 2007082418 A1